# EUROPÄISCHE PATENTSCHRIFT

(11) **EP 1 966 857 B1**
(45) Veröffentlichungstag und Bekanntmachung des Hinweises auf die Patenterteilung: **27.03.2013**
(21) Anmeldenummer: 06840895.4
(22) Anmeldetag: 29.12.2006
(51) Int. Cl.: H01S 5/022, H01S 5/04, H01S 5/40, H01S 5/00, H01S 5/14, H01S 5/183, H01S 5/024

(54) **VERTIKAL EMITTIERENDER, OPTISCH GEPUMPTER HALBLEITER MIT EXTERNEM RESONATOR AUF SEPARATEM SUBSTRAT**
VERTICALLY EMITTING, OPTICALLY PUMPED SEMICONDUCTOR HAVING AN EXTERNAL RESONATOR ON A SEPARATE SUBSTRATE
SEMI-CONDUCTEUR POMPÉ OPTIQUEMENT ÉMETTANT À LA VERTICALE MUNI D'UN RÉSONATEUR EXTERNE SUR UN SUBSTRAT SÉPARÉ

(30) Priorität: 30.12.2005 DE 102005063103; 12.04.2006 DE 102006017293
(43) Veröffentlichungstag der Anmeldung: 10.09.2008
(73) Patentinhaber: OSRAM Opto Semiconductors GmbH, 93055 Regensburg (DE)
(72) Erfinder: STEEGMÜLLER, Ulrich, 93055 Regensburg (DE); SINGER, Frank, 93128 Regenstauf (DE); SCHWARZ, Thomas, 93055 Regensburg (DE); SCHULZ, Roland, 93059 Regensburg (DE)
(74) Vertreter: Epping - Hermann - Fischer
(86) Internationale Anmeldenummer: PCT/DE2006/002337
(87) Internationale Veröffentlichungsnummer: WO 2007/076845

(56) Entgegenhaltungen:
- EP-A2- 0 939 464
- WO-A-2006/012819
- WO-A-2006/032252
- DE-A1-102004 012 014
- JP-A- 2005 202 082
- US-A- 5 637 885
- US-A1- 2005 147 360

## Beschreibung

Es wird ein Verfahren zur Herstellung einer optisch pumpbaren Halbleitervorrichtung angegeben.

Eine zu lösende Aufgabe besteht darin, ein Verfahren anzugeben, mit dem eine Halbleitervorrichtung besonders kostengünstig hergestellt werden kann.

Die Druckschrift US 2005/0147360 A1 beschreibt ein Lasermodul mit elektrisch gepumpten Halbleiterlasern, die je auf einem Anschlussträger angeordnet sind. Die Anschlussträger werden miteinander zum Modul verbunden.

Die Druckschrift US 6,637,885 beschreibt ein Mikrolasersystem, bei dem die Komponenten des Systems vertikal übereinander angeordnet werden.

Die Druckschrift DE 10 2004 012 014 A1 beschreibt einen Scheibenlaser mit einer Pumpanordnung, bei dem ein Halbleiterchip auf einer Montageplattform angeordnet ist und zum optischen Pumpen mittels einer Pumpanordnung optisch gepumpt wird. Die Pumpanordnung umfasst einen Pumplaser, ein Strahlformungselement, ein Umlenkelement und einen konkaven Spiegel.

Das erfindungsgemäße Verfahren ist in Anspruch 1 definiert. Vorteilhafte Ausfürungsformen in den abhängigen Ansprüchen.

Gemäß zumindest einer Ausführungsform des Verfahrens umfasst das Verfahren einen Verfahrensschritt, bei dem ein Anschlussträgerverbund bereitgestellt wird. Bei dem Anschlussträgerverbund handelt es sich vorzugsweise um einen Nutzen, der eine Mehrzahl von Anschlussträgern umfasst.

Das bedeutet, der Anschlussträgerverbund umfasst eine Mehrzahl von Anschlussträgern, die mechanisch fest miteinander verbunden sind. Jeder Anschlussträger des Anschlussträgerverbunds bildet nach dem Vereinzeln des Anschlussträgerverbunds einen separaten Anschlussträger. Vorzugsweise umfasst der Anschlussträgerverbund gleichartige Anschlussträger. Vor dem Vereinzeln des Verbundes können die Anschlussträger des Anschlussträgerverbunds elektrisch leitend miteinander verbunden sein.

Ein Anschlussträger des Anschlussträgerverbunds umfasst zum Beispiel einen Grundkörper, der aus einem elektrisch isolierenden, gut wärmeleitenden Material besteht. Auf die Oberfläche des Anschlussträgers sind Leiterbahnen aus einem elektrisch leitenden Material aufgebracht. Über die Leiterbahnen kann beispielsweise ein Halbleiterbauelement, das auf dem Anschlussträger aufgebracht ist, elektrisch kontaktierbar sein. Bevorzugt umfassen alle Anschlussträger des Anschlussträgerverbunds einen gemeinsamen Grundkörper, über den die Anschlussträger des Verbunds mechanisch miteinander verbunden sind.

Es wird ein oberflächenemittierender Halbleiterkörper auf einen Anschlussträger des Anschlussträgerverbunds angeordnet. Es wird auf jedem Anschlussträger des Verbunds genau ein oberflächenemittierender Halbleiterkörper angeordnet. Vorzugsweise handelt es sich bei den oberflächenemittierenden Halbleiterkörpern um gleichartige Halbleiterkörper mit gleichen oder ähnlichen physikalischen Eigenschaften. Beispielsweise können diese Halbleiterkörper gemeinsam gefertigt sein.

Der Halbleiterkörper weist eine Strahlungsdurchtrittsfläche auf, durch die elektromagnetische Strahlung in den Halbleiterkörper eingekoppelt und aus dem Halbleiterkörper ausgekoppelt werden kann. Insbesondere ist der Halbleiterkörper durch die Strahlungsdurchtrittsfläche optisch pumpbar. Das bedeutet, Pumpstrahlung, die durch die Strahlungsdurchtrittsfläche in den Halbleiterkörper eingekoppelt wird, regt im Halbleiterkörper die Erzeugung elektromagnetischer Strahlung an, die den Halbleiterkörper dann wiederum durch die Strahlungsdurchtrittsfläche verlässt. Der Halbleiterkörper ist dabei geeignet, unter Verwendung eines extern angeordneten, das heißt vom Halbleiterkörper beabstandet angeordneten Resonatorspiegels, Laserstrahlung zu erzeugen. Bevorzugt wird der Halbleiterkörper derart auf dem Anschlussträger angeordnet, dass seine Strahlungsdurchtrittsfläche vom Anschlussträger weggerichtet ist. Besonders bevorzugt verläuft die Strahlungsdurchtrittsfläche dabei parallel zum Anschlussträger.

Der Anschlussträgerverbund wird in einem weiteren Verfahrensschritt in einzelne Anschlussträger vereinzelt. Die einzelnen Anschlussträger stellen dann Anschlussträger je einer optisch pumpbaren Halbleitervorrichtung dar.

Zur Herstellung einer optisch pumpbaren Halbleitervorrichtung weist das Verfahren die folgenden Schritte auf: Zunächst wird ein Anschlussträgerverbund umfassend eine Mehrzahl von Anschlussträgern, die mechanisch fest miteinander verbunden sind, bereitgestellt. Nachfolgend wird ein oberflächenemittierender Halbleiterkörper auf einem Anschlussträger des Anschlussträgerverbunds angeordnet. In einem abschließenden Verfahrensschritt werden einzelnen Halbleitervorrichtungen beispielsweise unter Vereinzeln des Anschlussträgerverbunds hergestellt.

Das Verfahren umfasst einen weiteren Verfahrensschritt, bei dem eine Pumpstrahlungsquelle auf einem Anschlussträger des Anschlussträgerverbunds aufgebracht wird. Die Pumpstrahlungsquelle kann beispielsweise einen kantenemittierenden Halbleiterlaser oder einen kantenemittierenden Halbleiterlaserbarren umfassen. Ferner kann die Pumpstrahlungsquelle ein Wärmeleitelement umfassen, auf das der Halbleiterlaser aufgebracht ist. Auf jedem Anschlussträger des Verbunds wird genau eine Pumpstrahlquelle angeordnet, die geeignet ist, den auf denselben Anschlussträger angeordneten oberflächenemittierenden Halbleiterkörper optisch zu pumpen.

Gemäß einem Verfahrensschritt des hier beschriebenen Verfahrens wird ein optisches Element, das geeignet ist, Pumpstrahlung auf eine Strahlungsdurchtrittsfläche des Halbleiterkörpers zu lenken, auf einen Anschlussträger des Anschlussträgerverbunds angeordnet. Auf jedem Anschlussträger des Anschlussträgerverbunds wird wenigstens ein solches optisches Element angeordnet. Das optische Element wird derart auf dem Anschlussträger angeordnet, dass es geeignet ist, Pumpstrahlung auf die Strahlungsdurchtrittsfläche des Halbleiterkörpers zu lenken. Das bedeutet, Pumpstrahlung wird im Betrieb der fertig gestellten Halbleitervorrichtung von einer Pumpstrahlungsquelle nicht direkt auf die Strahlungsdurchtrittsfläche des Halbleiterkörpers gerichtet, sondern die Pumpstrahlung durchläuft oder trifft auf zumindest ein optisches Element, das die Pumpstrahlung auf die Strahlungsdurchtrittsfläche des Halbleiterkörpers lenkt.

Gemäß zumindest einer Ausführungsform des Verfahrens ist das optische Element geeignet, die Pumpstrahlung durch optische Brechung auf die Strahlungsdurchtrittsfläche des Halbleiterkörpers zu lenken. Das heißt beim Durchlaufen der Strahlungsdurchtrittsflächen des optischen Elements wird die Pumpstrahlung aufgrund des Brechungsindexunterschieds des optischen Elements und des umgebenden Materials - beispielsweise Luft - derart umgelenkt, dass die Pumpstrahlung nach Durchlaufen des optischen Elements auf die Strahlungsdurchtrittsfläche des Halbleiterkörpers gerichtet ist.

Gemäß zumindest einer Ausführungsform des Verfahrens ist das optische Element geeignet, die Pumpstrahlung durch eine Reflexion auf die Strahlungsdurchtrittsfläche des Halbleiterkörpers zu lenken. Das heißt es handelt sich bei dem optischen Element um ein reflektierendes optisches Element. Vorzugsweise ist das optische Element geeignet, die Pumpstrahlung durch eine einzige Reflexion auf die Strahlungsdurchtrittsfläche des Halbleiterkörpers zu lenken. Das heißt bei dem optischen Element handelt es sich vorzugsweise nicht um einen Lichtleiter, bei dem Pumpstrahlung durch eine Mehrzahl von Reflexionen umgelenkt wird. Beispielsweise handelt es sich bei dem optischen Element um einen hochreflektierenden Spiegel.

Im Betrieb der gemäß dem Verfahren hergestellten Halbleitervorrichtung läuft Pumpstrahlung zum Beispiel zumindest streckenweise zunächst parallel oder im Wesentlichen parallel zur Strahlungsdurchtrittsfläche des Halbleiterkörpers. Die Pumpstrahlung verläuft über die Strahlungsdurchtrittsfläche des Halbleiterkörpers hinweg. Das heißt die Pumpstrahlung verläuft zunächst über den Halbleiterkörper hinweg, ohne auf den Halbleiterkörper zu treffen. Das reflektierende optische Element ist dem Halbleiterkörper dann in Richtung der Pumpstrahlung nachgeordnet. Die Pumpstrahlung trifft - nachdem sie den Halbleiterkörper und damit die Strahlungsdurchtrittsfläche des Halbleiterkörpers überquert hat- auf das reflektierende optische Element. Vom reflektierenden optischen Element wird die Pumpstrahlung durch eine Reflexion auf die Strahlungsdurchtrittsfläche des Halbleiterkörpers gelenkt.

Die umgelenkte Pumpstrahlung kann dabei - zumindest für eine kurze Wegstrecke - in entgegengesetzter Richtung zu der Richtung der Pumpstrahlung verlaufen, die die Pumpstrahlung vor Auftreffen auf das reflektierende optische Element hat.

Gemäß zumindest einer Ausführungsform des Verfahrens wird das optische Element derart angeordnet, dass es geeignet ist, die Pumpstrahlung in Richtung der Montageebene des Halbleiterkörpers zu lenken. Das heißt die Pumpstrahlung verläuft bevor sie auf das optische Element trifft zunächst für eine bestimmte Wegstrecke parallel zur Montageebene oder ist von der Montageebene weggerichtet. In jedem Fall verläuft die Pumpstrahlung für diese Wegstrecke in einer bestimmten Höhe über der Montageebene und vorzugsweise auch über der Strahlungsdurchtrittsfläche des Halbleiterkörpers. Das optische Element ist geeignet, die Pumpstrahlung nach untenin Richtung der Montageebene und damit in Richtung der Strahlungsdurchtrittsfläche des Halbleiterkörpers - zu lenken.

Der Halbleiterkörper wird in der Montageebene des Halbleiterkörpers zwischen Pumpstrahlungsquelle und optischem Element angeordnet. Das heißt Pumpstrahlung läuft über den Halbleiterkörper hinweg, bevor sie auf die Strahlungsdurchtrittsfläche des Halbleiterkörpers gelenkt wird. Pumpstrahlungsquelle, Halbleiterkörper und optisches Element werden in dieser Reihenfolge entlang einer geraden Linie angeordnet. Die Anschlussträger sind im Anschlussträgerverbund matrixartig angeordnet. Das heißt der Anschlussträgerverbund weist eine Mehrzahl von Zeilen und Spalten auf, wobei jeder Anschlussträger des Anschlussträgerverbunds ein Matrixelement bildet. Das heißt jedem Anschlussträger des Verbunds ist eineindeutig eine bestimmte Zeilen- und Spaltennummer zugeordnet. Der matrixartige Aufbau des Anschlussträgerverbunds erlaubt beispielsweise in besonders einfacher Weise, eine Vielzahl von Elementen im Verbund gleichzeitig auf den Anschlussträgerverbund und damit auf jeden einzelnen Anschlussträger des Verbunds anzuordnen.

So werden gemäß zumindest einer Ausführungsform des Verfahrens gleichartige Elemente im Verbund auf den Anschlussträgerverbund aufgebracht. Beispielsweise kann es sich bei den gleichartigen Elementen um optische Elemente handeln. Die optischen Elemente können beispielsweise als streifenartiger Verbund ausgebildet sein. Beispielsweise umfasst jeder Verbund eine Anzahl optischer Elemente, die der Zahl der Spalten des Anschlussträgerverbunds entsprechen kann. Vorzugsweise wird in zumindest zwei Zeilen des Anschlussträgerverbunds ein solcher Verbund von gleichartigen Elementen angeordnet. Besonders bevorzugt wird in jeder Zeile des Anschlussträgerverbunds ein solcher Verbund von gleichartigen Elementen angeordnet. Das heißt auf jedem Anschlussträger des Verbunds befindet sich dann die gleiche Anzahl von Elementen, beispielsweise je genau ein solches Element. Dabei kann die Bestückung der einzelnen Zeilen des Anschlussträgerverbunds sequenziell oder gleichzeitig erfolgen.

Gemäß zumindest einer Ausführungsform weist der Anschlussträgerverbund wenigstens zwei Hauptjustagemarken auf. Die Hauptjustagemarken auf dem Anschlussträgerverbund dienen zur Orientierung des Anschlussträgerverbunds beispielsweise in einem Bestückungsautomaten mittels eines Bildverarbeitungssystems. Zumindest die ungefähren Ablagepositionen der einzelnen Elemente auf den einzelnen Anschlussträger des Anschlussträgerverbunds können dann abhängig von der Lage der beiden Hauptjustagemarken berechnet werden. "Zumindest ungefähr" bedeutet dabei, dass ausgehend von den Hauptjustagemarken zumindest die Lage einzelner Anschlussträger im Verbund errechnet werden kann. Auf den Anschlussträgern selbst können dann weitere Orientierungshilfen, beispielsweise Nebenjustagemarken, für das Bildverarbeitungssystem angeordnet sein.

Die Hauptjustagemarken können sich beispielsweise in zwei diagonal gegenüber liegenden Ecken des Anschlussträgerverbunds auf der Oberseite des Anschlussträgerverbunds, auf der die oben genannten Elemente abgelegt sind, befinden. Bei den Hauptjustagemarken kann es sich um Strukturierungen des Anschlussträgerverbundes oder um Justagechips handeln, die vor Bestückung des Anschlussträgerverbunds auf dem Anschlussträgerverbund befestigt werden.

Gemäß zumindest einer Ausführungsform weist zumindest ein Anschlussträger des Anschlussträgerverbunds zumindest eine Nebenjustagemarke auf. Bevorzugt weist jeder Anschlussträger des Verbunds wenigstens eine Nebenjustagemarke auf. Besonders bevorzugt weist jeder Anschlussträger eine Mehrzahl von Nebenjustagemarken auf. Die Nebenjustagemarken sind beispielsweise durch Ablagestrukturen gebildet, welche die Ablageposition einzelner Elemente auf dem Anschlussträger markieren. Bei den Ablagestrukturen kann es sich zum Beispiel um fototechnisch strukturierte Dünnschichten handeln.

Gemäß zumindest einer Ausführungsform des Verfahrens wird in einem Verfahrensschritt ein Resonatoraufsatz auf einem Anschlussträger des Verbunds angeordnet. Vorzugsweise wird auf jedem Anschlussträger des Verbunds genau ein Resonatoraufsatz angeordnet. Der Resonatoraufsatz wird dabei derart angeordnet, dass er der Strahlungsdurchtrittsfläche des Halbleiterkörpers in einer Hauptabstrahlrichtung des Halbleiterkörpers nachgeordnet ist.

Der Resonatoraufsatz umfasst beispielsweise einen zweiten Träger - einen Einzelträger, auf dem ein Resonatorspiegel befestigt ist. Der Resonatoraufsatz ist vorzugsweise parallel oder im Wesentlichen parallel zur Montageebene des Halbleiterkörpers über der Montageebene des Halbleiterkörpers angeordnet.

Beispielsweise sind auf jedem Anschlussträger Beabstandungselemente angeordnet, auf denen der Resonatoraufsatz befestigt wird. Die Beabstandungselemente werden zum Beispiel auf dem Anschlussträger befestigt. Auf den Beabstandungselementen ist der Resonatoraufsatz befestigt.

Gemäß zumindest einer Ausführungsform umfasst das Beabstandungselement ein optisches Element oder das Beabstandungselement ist aus einem optischen Element gebildet. Beispielsweise kann das Beabstandungselement dabei das optische Element umfassen oder aus dem optischen Element bestehen, das geeignet ist, Pumpstrahlung auf die Strahlungsdurchtrittsfläche des Halbleiterkörpers zu lenken.

Ferner ist es jedoch auch möglich, dass Beabstandungselemente der Halbleitervorrichtung andere optische Funktionen wahrnehmen. Beispielsweise kann eines der Beabstandungselemente geeignet sein, die Richtung der Pumpstrahlung zu verändern, so dass die Pumpstrahlung nach Durchlauf des Beabstandungselements von der Montageebene des Halbleiterkörpers weggerichtet ist.

Gemäß zumindest einer Ausführungsform des Verfahrens wird ein Resonatoraufsatz zur Anordnung auf einem Anschlussträger mit den folgenden Schritten gefertigt: Zunächst wird ein Trägerverbund bereitgestellt. Der Trägerverbund umfasst vorzugsweise eine Mehrzahl von Einzelträgerbereichen, die mechanisch fest miteinander verbunden sind.

Gemäß zumindest einer Ausführungsform des Verfahrens wird auf jedem Einzelträgerbereich ein Resonatorspiegel angeordnet. Vorzugsweise wird auf jedem Einzelträgerbereich genau ein Resonatorspiegel angeordnet. In einem weiteren Verfahrensschritt wird der Resonatoraufsatz beispielsweise durch Vereinzeln des Trägerverbunds in Einzelträger fertiggestellt.

Gemäß zumindest einer Ausführungsform des Verfahrens wird ein Strahlungsumlenkelement auf einem Einzelträgerbereich des Trägerverbunds angeordnet. Vorzugsweise handelt es sich bei dem Strahlungsumlenkelement um einen Umlenkspiegel, der für die im Resonator umlaufende elektromagnetische Strahlung der Grundwellenlänge hoch reflektierend ist. Vorzugsweise wird auf jedem Einzelträgerbereich genau ein Umlenkelement angeordnet. Bei dem Umlenkelement kann es sich beispielsweise um einen Umlenkspiegel handeln. Vom Halbleiterkörper im Betrieb emittierte elektromagnetische Strahlung trifft zunächst auf das Umlenkelement und von dort auf den Resonatorspiegel. Vom Resonatorspiegel wird die Laserstrahlung wiederum auf das Umlenkelement zurückgeworfen, der die Strahlung durch die Strahlungsdurchtrittsfläche in den Halbleiterkörper lenkt. Der Halbleiterkörper umfasst beispielsweise eine reflektierende Schichtenfolge, zum Beispiel einen Bragg-Spiegel, der einen weiteren Resonatorspiegel des derart gebildeten Laserresonators bildet.

Gemäß zumindest einer Ausführungsform des Verfahrens sind die Einzelträger im Trägerverbund matrixartig angeordnet. Das heißt der Trägerverbund umfasst eine Mehrzahl von Zeilen und Spalten, wobei jeder Einzelträgerbereich des Trägerverbunds ein Matrixelement bildet. Das heißt jedem Einzelträger des Trägerverbunds ist eineindeutig eine bestimmte Zeilen- und Spaltennummer zugeordnet. Die matrixartige Ausgestaltung des Trägerverbunds erlaubt beispielsweise in besonders einfacher Weise eine Vielzahl von Elementen im Verbund gleichzeitig auf den Trägerverbund und damit auf jeden Einzelträgerbereich anzuordnen. So werden gemäß zumindest einer Ausführungsform des Verfahrens gleichartige Elemente im Verbund auf den Trägerverbund aufgebracht. Beispielsweise kann es sich bei den gleichartigen Elementen um optische Elemente wie beispielsweise Resonatorspiegel handeln. Die optischen Elemente können zum Beispiel als streifenartiger Verbund ausgebildet sein. Ein solcher streifenartiger Verbund umfasst vorzugsweise eine Anzahl optischer Elemente, die der Zahl der Spalten des Trägerverbunds entspricht. Vorzugsweise in jeder Zeile des Trägerverbunds wird ein solcher streifenartiger Verbund von gleichartigen Elementen angeordnet, sodass auf jedem Einzelträgerbereich des Verbunds die gleiche Anzahl dieser Elemente - beispielsweise jeweils genau ein solches Element - angeordnet ist. Dabei kann die Bestückung einzelner Zeilen des Trägerverbunds sequenziell oder gleichzeitig erfolgen.

Gemäß zumindest einer Ausführungsform des Verfahrens wird auf einem Einzelträgerbereich des Trägerverbunds zumindest ein Element mittels Bonden befestigt. Vorzugsweise wird auf jedem Einzelträgerbereich zumindest ein Element mittels Bonden befestigt. Beispielsweise können die Elemente mittels "Direct Bonding" oder anodischem Bonden befestigt werden. Bei den Elementen handelt es sich vorzugsweise um zumindest eines der folgenden Elemente: Umlenkelement, Resonatorspiegel, frequenzkonvertierendes Element. Mittels Bonden ist es insbesondere auch möglich, die auf dem Trägerverbund angeordneten Elemente gleichzeitig zu befestigen.

Gemäß zumindest einer Ausführungsform des Verfahrens wird vor dem Anordnen der Elemente auf dem Trägerverbund eine strukturierte Metallbeschichtung auf einem Einzelträgerbereich aufgebracht. Bevorzugt wird auf jedem Einzelträgerbereich eine strukturierte Metallbeschichtung aufgebracht. Die Metallbeschichtung weist vorzugsweise elektrische Kontaktstellen zum Kontaktieren der Metallbeschichtung auf. Bevorzugt umfasst jeder Einzelträgerbereich eine Metallbeschichtung, mittels der die Temperatur des Resonatoraufsatzes in der gemäß dem Verfahren hergestellten Halbleitervorrichtung erhöht und/oder ermittelt werden kann. Vorzugsweise kann die Temperatur des Resonatoraufsatzes mittels der Metallbeschichtung erhöht und ermittelt werden. Bei der Metallbeschichtung handelt es sich vorzugsweise um eine strukturierte Metallbeschichtung. Zum Beispiel wird die Metallbeschichtung mäanderartig ausgebildet oder die Metallbeschichtung weist eine Mehrzahl von Ausnehmungen auf. Die Metallbeschichtung enthält oder besteht vorzugsweise aus zumindest einem der folgenden Metalle: Platin, Gold.

Die Metallbeschichtung weist vorzugsweise ferner Kontaktstellen auf, mittels derer die Metallbeschichtung elektrisch kontaktierbar ist. Durch Bestromen der Metallbeschichtung kann die Temperatur des Resonatoraufsatzes im Betrieb der fertiggestellten Halbleitervorrichtung gezielt erhöht werden. Auf diese Weise kann das Frequenzkonversionselement beispielsweise auf eine vorgebbare Betriebstemperatur aufgeheizt werden. Ferner kann - beispielsweise durch die Messung des temperaturabhängigen elektrischen Widerstands der Metallbeschichtung - die Temperatur der Metallbeschichtung und damit die Temperatur des Resonatoraufsatzes und des Frequenzkonversionselements ermittelt werden.

Vorzugsweise wird die Metallbeschichtung dazu mit einer Steuervorrichtung verbunden, die geeignet ist, eine von außen vorgebbare Temperatur der Metallbeschichtung einzustellen und zu regeln. Die Steuervorrichtung kann beispielsweise einen Mikrocontroller umfassen. Die Steuervorrichtung kann auf dem Anschlussträger der Halbleitervorrichtung angeordnet wird. Dazu kann in einem Verfahrenschritt des Verfahrens zur Herstellung einer optisch pumpbaren Halbleitervorrichtung auf jeden Anschlussträger des Anschlussträgerverbunds eine Steuervorrichtung angeordnet werden. Es ist aber auch möglich, dass die Steuervorrichtung außerhalb der Halbleitervorrichtung angeordnet wird und elektrisch leitend mit der Halbleitervorrichtung verbunden wird.

Gemäß zumindest einer Ausführungsform des Verfahrens wird jeder Resonatoraufsatz elektrisch leitend mit dem Anschlussträger, auf dem der Resonatoraufsatz angeordnet ist, verbunden. Dies kann beispielsweise mittels Anschlussdrähten geschehen, die die Kontaktstellen der Metallbeschichtung mit dem Anschlussträger verbinden.

Im Folgenden werden das hier beschriebene Verfahren sowie gemäß dem hier beschriebenen Verfahren hergestellte Halbleitervorrichtung anhand von Ausführungsbeispielen und den dazugehörigen Figuren näher erläutert.
- Figur 1A: zeigt die Pumpeinheit einer gemäß dem hier beschriebenen Verfahren hergestellten Halbleitervorrichtung gemäß einem ersten Ausführungsbeispiel der Halbleitervorrichtung in einer schematischen Schnittdarstellung.
- Figur 1B: zeigt die Pumpeinheit der gemäß dem hier beschriebenen Verfahren hergestellten Halbleitervorrichtung gemäß dem ersten Ausführungsbeispiel in einer schematischen Draufsicht.
- Figur 1C: zeigt eine gemäß dem hier beschriebenen Verfahren hergestellte Halbleitervorrichtung gemäß einem zweiten Ausführungsbeispiel in einer schematischen Schnittansicht.
- Figur 1D: zeigt die gemäß dem hier beschriebenen Verfahren hergestellte Halbleitervorrichtung gemäß dem zweiten Ausführungsbeispiel in einer schematischen Perspektivdarstellung.
- Figur 1E: zeigt die Pumpeinheit einer gemäß dem hier beschriebenen Verfahren hergestellten Halbleitervorrichtung gemäß dem ersten oder dem zweiten Ausführungsbeispiel der Halbleitervorrichtung in einer schematischen Schnittdarstellung.
- Figur 1F: zeigt die Pumpeinheit einer gemäß dem hier beschriebenen Verfahren hergestellten Halbleitervorrichtung gemäß dem ersten oder dem zweiten Ausführungsbeispiel in einer schematischen Draufsicht.
- Figur 2A: zeigt eine schematische Perspektivdarstellung einer Pumpeinheit der gemäß dem hier beschriebenen Verfahren hergestellten Halbleitervorrichtung gemäß einem dritten Ausführungsbeispiel.
- Figur 2B: zeigt die gemäß dem hier beschriebenen Verfahren hergestellte Halbleitervorrichtung in einer schematischen Perspektivdarstellung unter einem ersten Winkel betrachtet.
- Figur 2C: zeigt die gemäß dem hier beschriebenen Verfahren hergestellte Halbleitervorrichtung gemäß dem dritten Ausführungsbeispiel unter einem zweiten Winkel betrachtet.
- Figur 2D: zeigt die gemäß dem hier beschriebenen Verfahren hergestellte Halbleitervorrichtung gemäß dem dritten Ausführungsbeispiel in einer schematischen Draufsicht.
- Figuren 2E: und 2F zeigen schematische Seitenansichten der gemäß dem hier beschriebenen Verfahren hergestellten Halbleitervorrichtungen gemäß dem dritten Ausführungsbeispiel aus unterschiedlichen Betrachtungsrichtungen.
- Figur 2G: zeigt die Pumpeinheit der gemäß dem hier beschriebenen Verfahren hergestellten Halbleitervorrichtung gemäß dem dritten Ausführungsbeispiel vor Bestückung mit passiven optischen Elementen in einer schematischen Seitenansicht, Figur 2H zeigt die zugehörige schematische Draufsicht.
- Figuren: 3A, 3B, 3C und 3D zeigen in einer schematischen Draufsicht die Herstellung von Resonatoraufsätzen 40 gemäß einem Ausführungsbeispiel des hier beschriebenen Verfahrens.
- Figur 3E: zeigt in einer schematischen Seitenansicht einen derart hergestellten Resonatoraufsatz 40.
- Figur 3F: zeigt eine schematische Draufsicht auf einen derart hergestellten Resonatoraufsatz 40. In Verbindung mit den Figuren.4A bis 4D ist ein Herstellungsverfahren zur Herstellung der Resonatorspiegel 31 beschrieben, wie es gemäß eines Ausführungsbeispiels des hier beschrieben Verfahrens zum Einsatz kommt.
- Figur 5: zeigt einen Anschlussträgerverbund 50 mit einer Vielzahl von matrixartig angeordneten Anschlussträgern 14 wie er in einem Ausführungsbeispiel des hier beschriebenen Verfahrens Verwendung findet.
- Figur 6A: zeigt eine schematische Draufsicht auf einen Anschlussträgerverbund 50 mit einer Vielzahl von matrixartig angeordneten Anschlussträgern 14, wie er in einem weiteren Ausführungsbeispiel des hier beschriebenen Verfahrens Verwendung findet.
- Figur 6B: zeigt eine schematische Draufsicht auf die Rückseite des Anschlussträgers 50.
- Figur 6C: zeigt eine schematische Seitenansicht des Anschlussträgers 50.
- Figur 6D: zeigt eine schematische Draufsicht auf einen Anschlussträger 14 des Anschlussträgerverbundes 50.

In den Ausführungsbeispielen und Figuren sind gleiche oder gleich wirkende Bestandteile jeweils mit den gleichen Bezugszeichen versehen. Die dargestellten Elemente sind nicht als maßstabsgerecht anzusehen, vielmehr können einzelne Elemente zum besseren Verständnis übertrieben groß dargestellt sein.

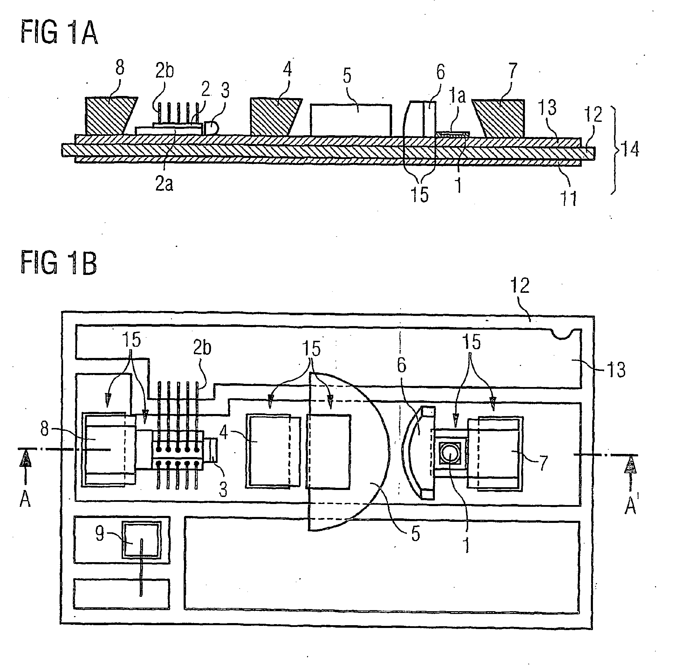

Figur 1A zeigt die Pumpeinheit einer gemäß dem hier beschriebenen Verfahren hergestellten Halbleitervorrichtung gemäß einem ersten Ausführungsbeispiel der Halbleitervorrichtung in einer schematischen Schnittdarstellung.

Die Pumpeinheit umfasst einen Anschlussträger 14. Die Grundfläche der hier beschriebenen oberflächenemittierenden Halbleiterlaservorrichtungen - das heißt die Grundfläche des Anschlussträgers 14 - beträgt vorzugsweise zwischen 30 und 150 Quadratmillimeter. Der Anschlussträger 14 umfasst im hier gezeigten Ausführungsbeispiel einen Grundkörper 12, eine Unterseitenmetallisierung 11 sowie eine strukturierte Oberseitenmetallisierung 13. Bei dem Anschlussträger 14 handelt es sich vorzugsweise um einen Direct Bonded Copper (DBC) Verbundwerkstoff. Der Grundkörper 12 besteht beispielsweise aus einem keramischen Material wie einem AlN. Die Dicke des Grundkörpers 12 beträgt vorzugsweise zwischen 0,2 und 0,5 mm, besonders bevorzugt 0,38 mm. Die Oberseitenmetallisierung 13 sowie die Unterseitenmetallisierung 11 bestehen beispielsweise aus Kupfer und weisen eine Dicke zwischen 0,1 und 0,3 mm, vorzugsweise 0,2 mm auf. Vorteilhaft weist Kupfer eine hohe Wärmeleitfähigkeit von zirka 400 Watt pro Meter Kelvin auf. Durch den Verbund mit dem AlN-Grundkörper 12 wird der effektive thermische Ausdehnungskoeffizient des Anschlussträgers 14 an seiner Oberfläche gesenkt. Dies kommt der Montage von Halbleiterkörpern mit geringem Ausdehnungskoeffizienten zugute.

Die strukturierte Oberseitenmetallisierung 13 bildet Leiterbahnen, über die auf dem Anschlussträger 14 befestigte, aktive Halbleiterbauelemente elektrisch kontaktierbar sind.

Alternativ zum in Verbindung mit Figur 1A beschriebenen Anschlussträger 14 ist es auch möglich einen Anschlussträger 14 zu verwenden, der einen keramischen Grundkörper 12 umfasst, der beispielsweise aus AlN besteht. Auf die Oberseite des Grundkörpers 12 kann dann eine Oberseitenmetallisierung 13 aufgebracht sein. Dazu ist beispielsweise eine Goldmetallisierung mittels einer Maske direkt auf den Grundkörper 12 - zum Beispiel mittels Sputtern oder Aufdampfen - strukturiert. Die Dicke der Goldschicht beträgt dabei maximal 1 µm, vorzugsweise maximal 500 nm. Ein solcher Anschlussträger zeichnet sich gegenüber einem DBC-Anschlussträger durch eine besonders glatte Oberfläche aus. Die Dicke des Grundkörpers 12 beträgt dabei vorzugsweise maximal 1 mm, besonders bevorzugt maximal 0,7 mm. Metallische Sperren - beispielsweise für ein Lotmaterial - die zum Beispiel aus Platin oder NiCr bestehen können oder zumindest eines dieser Materialen enthalten, können direkt auf den Anschlussträger 14 durch Dampfen oder Sputtern abgeschieden und strukturiert werden.

Auf den Anschlussträger 14 ist ein oberflächenemittierender Halbleiterkörper 1 aufgebracht. Der oberflächenemittierende Halbleiterkörper 1 ist beispielsweise auf den Anschlussträger 14 aufgelötet oder aufgeklebt. Vorzugsweise ist der oberflächenemittierende Halbleiterköper 1 mittels einer Lotverbindung auf dem Anschlussträger 14 befestigt. Dazu eignet sich insbesondere ein Dünnschichtlot. Das heißt der oberflächenemittierende Halbleiterkörper 1 ist mittels eines Lots, das durch Sputtern oder Aufdampfen abgeschieden ist, befestigt. Das Lot enthält oder besteht vorzugsweise aus wenigstens einem der folgenden Materialien: AuSn, Sn, SnAg, In, InSn. Vorzugsweise beträgt die Dicke der Lotschicht zwischen 1 und 5 µm.

Der oberflächenemittierende Halbleiterkörper 1 umfasst eine reflektierende Schichtenfolge und eine strahlungserzeugende Schichtenfolge. Bei der reflektierenden Schichtenfolge handelt es sich vorzugsweise um eine reflektierende Metallschicht, einem Bragg-Spiegel oder eine Kombination dieser reflektierenden Schichten. Vorzugsweise handelt es sich bei der reflektierenden Schichtenfolge um einen Bragg-Spiegel der eine Mehrzahl von Halbleiterschichtenpaaren mit vorteilhaft hohem Brechungsindexunterschied aufweist. Bevorzugt umfasst der Bragg-Spiegel eine Abfolge von 20 bis 30 oder mehr Halbleiterschichtenpaare, woraus eine besonders hohe Reflektivität des Spiegels von 99,9 % oder höher resultiert. Mit Vorteil ist der Bragg-Spiegel gemeinsam mit den übrigen Halbleiterschichten des Halbleiterkörpers 1 epitaktisch hergestellt. Der Bragg-Spiegel ist vorzugsweise auf der dem Anschlussträger 14 zugewandten Seite des Halbleiterkörpers 1 angeordnet.

Die strahlungserzeugende Schichtenfolge des Halbleiterkörpers umfasst einen aktiven Bereich mit einem pn-Übergang und/oder einer Einfachquantentopfstruktur und/oder vorzugsweise einer Mehrfachquantentopfstruktur - besonders bevorzugt einer undotierten Mehrfachquantentopfstruktur -, die zur Strahlungserzeugung geeignet ist. Die Bezeichnung Quantentopfstruktur umfasst im Rahmen der Beschreibung insbesondere auch jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Vorzugsweise basiert die strahlungsemittierende Schichtenfolge auf einem III-V-Verbindungshalbleitermaterial. Das heißt die strahlungsemittierende Schichtenfolge umfasst mindestens eine Schicht, die aus einem III-V-Verbindungshalbleitermaterial besteht. Bevorzugt basiert die strahlungsemittierende Schichtenfolge auf einem Nitrid-, Phosphid- oder besonders bevorzugt Arsenid-Verbindungshalbleiter.

"Auf Nitrid-Verbindungshalbleitern basierend" bedeutet im vorliegenden Zusammenhang, dass die strahlungsemittierende Schichtenfolge oder.zumindest eine Schicht davon ein Nitrid-V-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die charakteristischen physikalischen Eigenschaften des AlₙGaₘIn₁₋ₙ₋ₘn-Materials im Wesentlichen nicht ändern. Der Einfachheit halber beinhaltet obige Formel jedoch nur die wesentlichen Bestandteile des Kristallgitters (A1, Ga, In, N), auch wenn diese teilweise durch geringe Mengen weiterer Stoffe ersetzt sein können.

"Auf Phosphid-Verbindungshalbleitern basierend" bedeutet in diesem Zusammenhang, dass die strahlungsemittierende Schichtenfolge oder zumindest eine Schicht davon vorzugsweise AlₙGaₘIn₁₋ₙ₋ₘP umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (A1, Ga, In, P), auch wenn diese teilweise durch geringe Mengen weiterer Stoffe ersetzt sein können.

"Auf Arsenid-Verbindungshalbleitern basierend" bedeutet in diesem Zusammenhang, dass die strahlungsemittierende Schichtenfolge oder zumindest eine Schicht davon vorzugsweise AlₙGaₘIn₁₋ₙ₋ₘAs umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (A1, Ga, In, As), auch wenn diese teilweise durch geringe Mengen weiterer Stoffe ersetzt sein können.

Diese Materialien zeichnen sich durch vereinfacht erreichbare hohe interne Quanteneffizienzen aus und eignen sich für Strahlung vom ultravioletten, insbesondere Nitrid-basiertes Verbindungshalbleitermaterial, über den sichtbaren, insbesondere Phosphid-basierte Verbindungshalbleitermaterialien, bis in den infraroten Spektralbereich, insbesondere Arsenid-basierte Verbindungshalbleitermaterialien.

Bevorzugt basiert die strahlungserzeugende Schichtenfolge des Halbleiterkörpers auf einem Arsenid-Verbindungshalbleitermaterial. Strahlung im infraroten Spektralbereich, insbesondere im Wellenbereich zwischen 800 nm und 1100 nm, kann in diesem Materialsystem besonders effizient erzeugt werden. Beispielsweise enthält der Träger Galliumarsenid und die strahlungsemittierende Schichtenfolge oder zumindest eine Schicht davon basiert auf dem Materialsystem AlₙGaₘIn₁₋ₙ₋ₘAs mit 0 ≤ n ≤ 1, 0 ≤ m ≤ 1 und n+m ≤ 1.

Weiter ist auf dem Anschlussträger 14 eine Pumpstrahlungsquelle 2 angeordnet. Die Pumpstrahlungsquelle 2 umfasst beispielsweise einen kantenemittierenden Halbleiterlaser sowie ein Wärmeelement 2a. Das Wärmeleitelement 2a besteht vorzugsweise aus einem gut wärmeleitenden Material, wie beispielsweise Diamant, Aluminiumnitrid oder Siliziumcarbid oder enthält zumindest eines dieser Materialien. Die Pumpstrahlungsquelle 2 ist mittels Anschlussdrähten 2b elektrisch leitend an den Anschlussträger 14 angeschlossen. Vorzugsweise ist die Pumpstrahlungsquelle 2 mittels einer Lotverbindung auf dem Anschlussträger 14 befestigt. Dazu eignet sich insbesondere ein Dünnschichtlot. Das heißt die Pumpstrahlungsquelle 2 ist mittels eines Lots, das durch Sputtern oder Dampfen abgeschieden ist, befestigt. Das Lot enthält oder besteht vorzugsweise aus wenigstens einem der folgenden Materialien: AuSn, Sn, SnAg, In, InSn. Vorzugsweise beträgt die Dicke der Lotschicht zwischen 1 und 5 µm.

Der Pumpstrahlungsquelle 2 ist eine Linse 3 nachgeordnet. Die Linse 3 dient beispielsweise zur fast axis collimination (FAC) der von der Pumpstrahlquelle 2 emittierten Pumpstrahlung 17. Die Linse 3 weist dazu beispielsweise eine asphärisch gekrümmte Strahlungsaustrittsfläche auf und kann aus einem hochbrechenden Material wie GaP bestehen.

Der Linse 3 ist in Hauptabstrahlrichtung der Pumpstrahlquelle 2 ein weiteres optisches Element 4 nachgeordnet. Das optische Element 4 ist vorzugsweise zur Brechung der durchtretenden Pumpstrahlung geeignet. Beispielsweise ist das optische Element 4 geeignet, die Pumpstrahlung 17 vom Anschlussträger 14 weg zu brechen oder zu lenken. Das optische Element 4 enthält vorzugsweise ein Glas.

Dem optischen Element 4 sind eine Zylinderlinse 5 sowie eine sphärische Linse 6 nachgeordnet. Die Linsen 5, 6 dienen zur slow axis collimination (SAC) und/oder fast axis collimination der durchtretenden Pumpstrahlung. Beispielsweise können die beiden Linsen 5, 6 auch durch eine einzige Zylinderlinse mit asphärisch gekrümmter Strahlungsdurchtrittsfläche ersetzt sein. Von den Linsen 5, 6 gelangt die Pumpstrahlung auf das Umlenkelement 7.

Das Umlenkelement 7 enthält beispielsweise ein Glas, wobei die dem oberflächenemittierenden Halbleiterkörper zugewandte Fläche für die Pumpstrahlung hochreflektierend beschichtet ist. Das Umlenkelement 7 lenkt die auftreffende Pumpstrahlung auf die Strahlungsdurchtrittsfläche 1a des oberflächenemittierenden Halbleiterkörper 1, derart, dass Pumpstrahlung 17 vorzugsweise unter einem spitzen Winkel auf die Strahlungsdurchtrittsfläche 1a trifft.

Weiter kann ein Beabstandungselement 8 auf dem Träger 14 angeordnet sein. Bei den Elementen 8, 4, 7 kann es sich um Elemente handeln, die gleichartig geformt sind und aus dem gleichen Material bestehen. Sie unterscheiden sich dann lediglich durch reflektierend, entspiegelt, oder unbeschichtet ausgebildete Oberflächen sowie ihre Orientierung auf dem Anschlussträger 14.

Die Figur 1B zeigt die Pumpeinheit der gemäß dem hier beschriebenen Verfahren hergestellten Halbleitervorrichtung gemäß dem ersten Ausführungsbeispiel in einer schematischen Draufsicht.

Wie der Figur 1B zu entnehmen ist, ist auf dem Anschlussträger 14 ferner ein Temperatursensor 9 aufgebracht, der beispielsweise einen NTC-Widerstand umfasst. Mittels des Temperatursensors 9 kann die mittlere Temperatur des Anschlussträgers 14 ermittelt werden. Abhängig von der mittleren Temperatur des Anschlussträgers 14 kann beispielsweise mit Hilfe eines thermoelektrischen Kühlers, der etwa an der Unterseite des Anschlussträgers 14 angeordnet sein kann, eine Betriebstemperatur der Pumpeinheit eingestellt werden. Bevorzugt beträgt die Betriebstemperatur der Pumpeinheit zwischen 20 und 35° C, besonders bevorzugt 25° C.

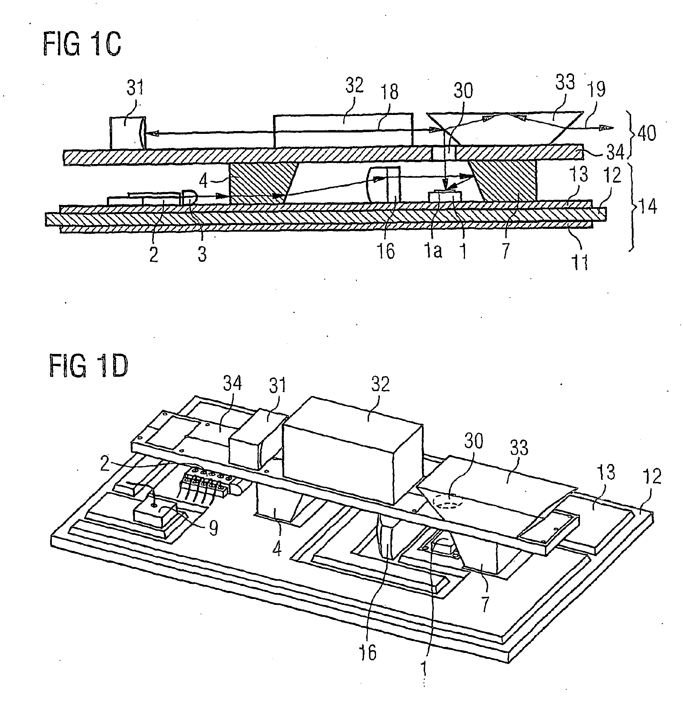

Figur 1C zeigt eine gemäß dem hier beschriebenen Verfahren hergestellte Halbleitervorrichtung gemäß einem zweiten Ausführungsbeispiel in einer schematischen Schnittansicht.

Der Pumpeinheit ist dabei in Hauptabstrahlrichtung des oberflächenemittierenden Halbleiterkörpers 1 ein Resonatoraufsatz 40 nachgeordnet.

Die Pumpeinheit umfasst einen Anschlussträger 14, wie er weiter oben beschrieben ist. Die Pumpeinheit umfasst ferner eine Pumpstrahlungsquelle 2, der eine FAC-Linse 3 nachgeordnet ist. Die Pumpstrahlung tritt von der FAC-Linse 3 durch_ein optisches Element 4, das die Pumpstrahlung 17 vom Anschlussträger 14 wegbricht. Nachfolgend tritt die Pumpstrahlung durch eine asphärische Linse 16, die zur Kolliminierung der Pumpstrahlung vorgesehen ist. Von dort trifft die Pumpstrahlung auf ein Umlenkelement 7, das die Pumpstrahlung auf die Strahlungsdurchtrittsfläche 1a des oberflächenemittierenden Halbleiterkörpers 1 lenkt. Die Pumpstrahlung 17 regt im Halbleiterkörper 1 die Erzeugung von Laserstrahlung 18 der Grundfrequenz an. Die Laserstrahlung 18 der Grundfrequenz tritt durch eine Ausnehmung 30, die sich im Träger 34 des Resonatoraufsatzes 40 befindet, in den Resonatoraufsatz 40 ein. Von einem Umlenkelement 33, das beispielsweise durch ein Dove-Prisma gebildet ist, wird die Laserstrahlung in Richtung eines Resonatorspiegels 31 gelenkt. Im Laserresonator ist vorzugsweise ein optisch nicht-linearer Kristall 32 angeordnet, der beispielsweise zur Frequenzvervielfachung der durchtretenden Laserstrahlung dient. Ein Grossteil der derart erzeugten konvertierten Strahlung 19 wird durch das Umlenkelement 33 aus der Halbleitervorrichtung ausgekoppelt.

Bevorzugt umfasst der optisch nicht-lineare Kristall 32 zumindest einen der folgenden Kristalle: Lithiumtriborat zum Beispiel LiB₃O₅ (LBO), Wismuttriborat zum Beispiel BiB₃O₆ (BiBO), Kaliumtitanylphosphat KTiOPO₄ (KTP), magnesiumoxiddotiertes kongruentes Lithiumniobat zum Beispiel MgO:LiNbO₃ (MgO:LN), magnesiumoxiddotiertes stöchiometrisches Lithiumniobat zum Beispiel MgO:s-LiNbO₃ (MgO:SLN), magnesiumoxiddotiertes stöchiometrisches Lithiumtantalat zum Beispiel MgO:LiTaO₃ (MgO:SLT), stöchiometrisches LiNbO₃ (SLN), stöchiometrisches LiTaO₃ (SLT), RTP (RbTiOPO₄), KTA (KTiOAsO₄), RTA (RbTiOAsO₄), CTA (CsTiOAsO₄).

Bevorzugt ist der optisch nicht-lineare Kristall zur Frequenzverdoppelung der ihn durchtretenden Strahlung geeignet.

Ferner kann im Laserresonator ein frequenzselektives Element wie beispielsweise ein Etalon oder ein doppelbrechendes Filter angeordnet sein, das einen spektral stabilen und schmalbandigen Betrieb des Lasers vorteilhaft erleichtert.

Die Figur 1D zeigt die gemäß dem hier beschriebenen Verfahren hergestellte Halbleitervorrichtung gemäß dem zweiten Ausführungsbeispiel in einer schematischen Perspektivdarstellung.

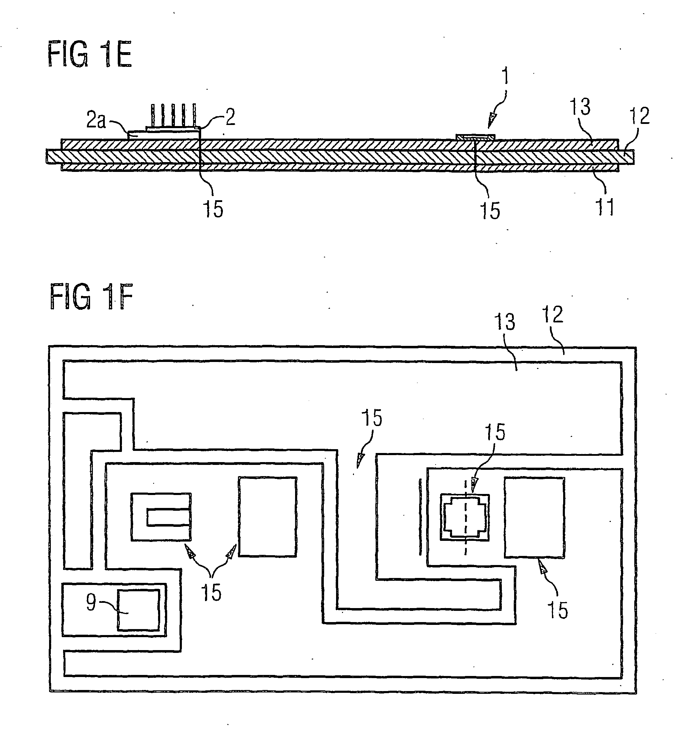

Figur 1E zeigt die Pumpeinheit einer gemäß dem hier beschriebenen Verfahren hergestellten Halbleitervorrichtung gemäß dem ersten oder dem zweiten Ausführungsbeispiel in einer schematischen Schnittdarstellung vor dem Aufbringen passiver optischer Elemente.

Figur 1F zeigt die Pumpeinheit einer gemäß dem hier beschriebenen Verfahren hergestellten Halbleitervorrichtung gemäß dem ersten oder dem zweiten Ausführungsbeispiel in einer schematischen Draufsicht.

Wie den Figuren 1E und 1F zu entnehmen ist, weist der Anschlussträger 14 Nebenjustagemarken 15 auf. Bei den Nebenjustagemarken 15 handelt es sich beispielsweise um Ablagestrukturen, die als fototechnisch strukturierte Dünnschichten ausgeführt sind.

Die Nebenjustagemarken dienen als Orientierungshilfen für ein Bildverarbeitungssystem, mittels dem die Ablagepositionen für die einzelnen Elemente der Halbleitervorrichtung auf dem Anschlussträger 14 ermittelt werden. Die Ablagegenauigkeit für die einzelnen Elemente beträgt dabei vorzugsweise zwischen +/- 5 µm bis +/- 50 µm. Besonders bevorzugt beträgt die Ablagegenauigkeit wenigstens +/- 10 µm.

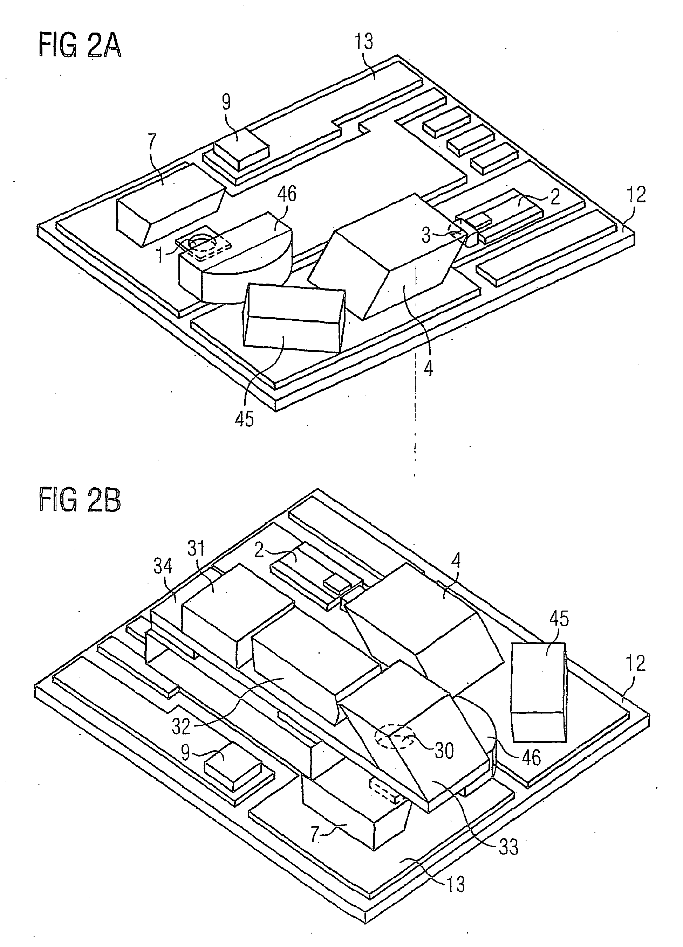

Figur 2A zeigt eine schematische Perspektivdarstellung einer Pumpeinheit der gemäß dem hier beschriebenen Verfahren hergestellten Halbleitervorrichtung gemäß einem dritten Ausführungsbeispiel. In diesem Ausführungsbeispiel ist die Grundfläche der Halbleitervorrichtung, das heißt die Fläche des Anschlussträgers 14 gegenüber den ersten beiden Ausführungsbeispielen um zirka 30 % reduziert. Im Gegensatz zum in Verbindung mit den Figuren 1A bis 1F beschriebenen Ausführungsbeispiel sind Pumpstrahlquelle 2, oberflächenemittierender Halbleiterkörper 1 sowie Umlenkoptik 7 hier nicht entlang einer geraden Linie angeordnet.

Pumpstrahlung tritt von der Pumpstrahlungsquelle 2 zunächst durch eine FAC-Linse 3. Von dort tritt die Pumpstrahlung durch ein optisches Element 4, das beispielsweise durch ein Durchstrahlprisma oder einen Parallelepiped gebildet ist. Vom Umlenkspiegel 45 wird die Pumpstrahlung dann auf eine asphärische Zylinderlinse 46 gerichtet, die die Pumpstrahlung weiter kolliminiert. Von dort trifft die Pumpstrahlung auf die Umlenkoptik 7, welche die Pumpstrahlung auf die Strahlungsdurchtrittsfläche des oberflächenemittierenden Halbleiterkörpers 1 lenkt.

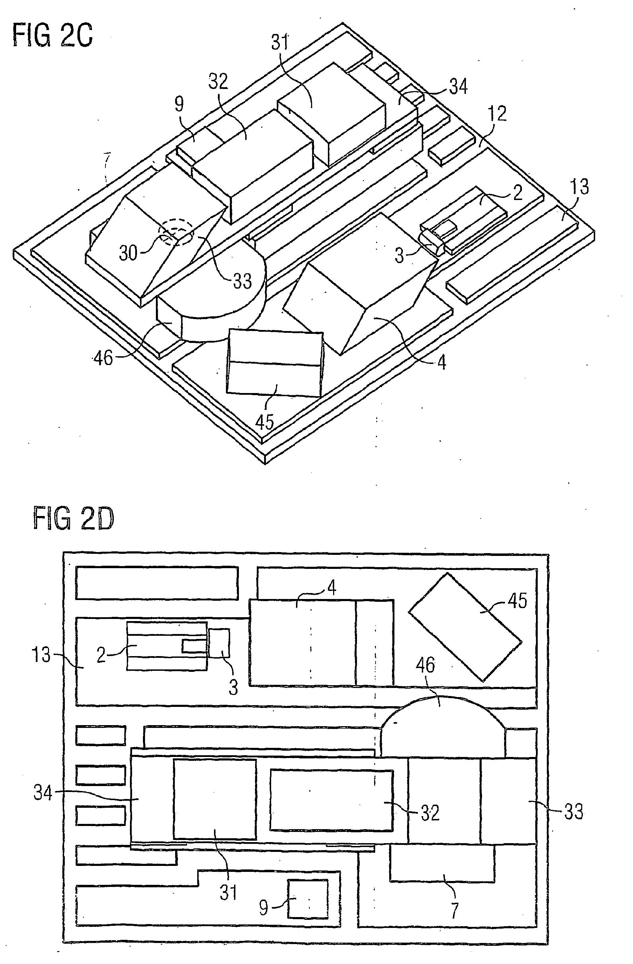

Figur 2B zeigt die gemäß dem hier beschriebenen Verfahren hergestellte Halbleitervorrichtung in einer schematischen Perspektivdarstellung unter einem ersten Winkel betrachtet. Figur 2C zeigt die gemäß dem hier beschriebenen Verfahren hergestellte Halbleitervorrichtung gemäß dem dritten Ausführungsbeispiel unter einem zweiten Winkel betrachtet.

Im Gegensatz zu den in Verbindung mit den Figuren 1A bis 1F beschriebenen Ausführungsbeispielen ist die Umlenkoptik 33 im dritten Ausführungsbeispiel nicht durch ein Dove-Prisma sondern durch einen Parallelepiped gebildet.

Figur 2D zeigt die gemäß dem hier beschriebenen Verfahren hergestellte Halbleitervorrichtung gemäß dem dritten Ausführungsbeispiel in einer schematischen Draufsicht.

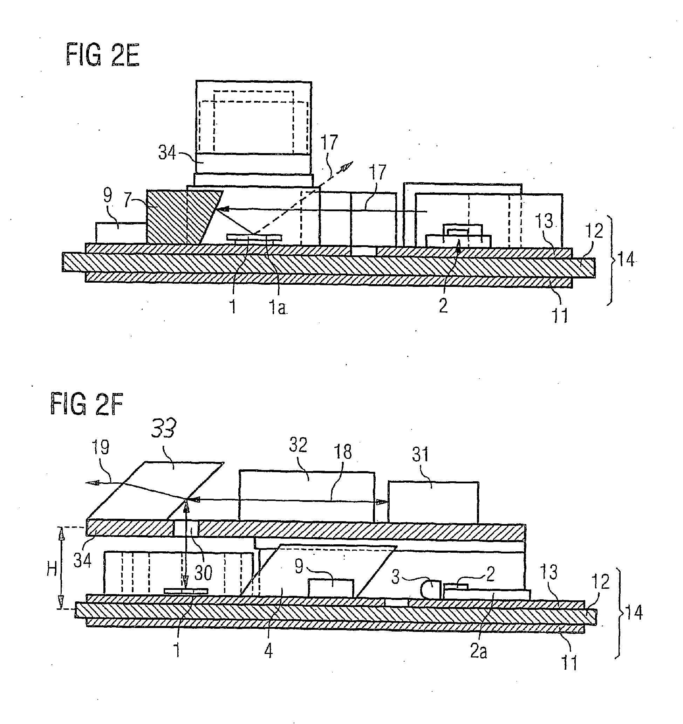

Die Figuren 2E und 2F zeigen schematische Seitenansichten der gemäß dem hier beschriebenen Verfahren hergestellten Halbleitervorrichtungen gemäß dem dritten Ausführungsbeispiel aus unterschiedlichen Betrachtungsrichtungen.

Wie der Figur 2E zu entnehmen ist, trifft bei der Halbleitervorrichtung gemäß dem zweiten Ausführungsbeispiel keine Pumpstrahlung, die gegebenenfalls an der Strahlungsdurchtrittsfläche 1a des oberflächenemittierenden Halbleiterkörpers 1 reflektiert wird, in den optisch nicht-linearen Kristall. Auf diese Weise kann vorteilhaft eine besonders stabile Frequenzkonversion erfolgen, da der optisch nicht-lineare Kristall 32 durch die reflektierte Pumpstrahlung 17 nicht aufgeheizt werden kann.

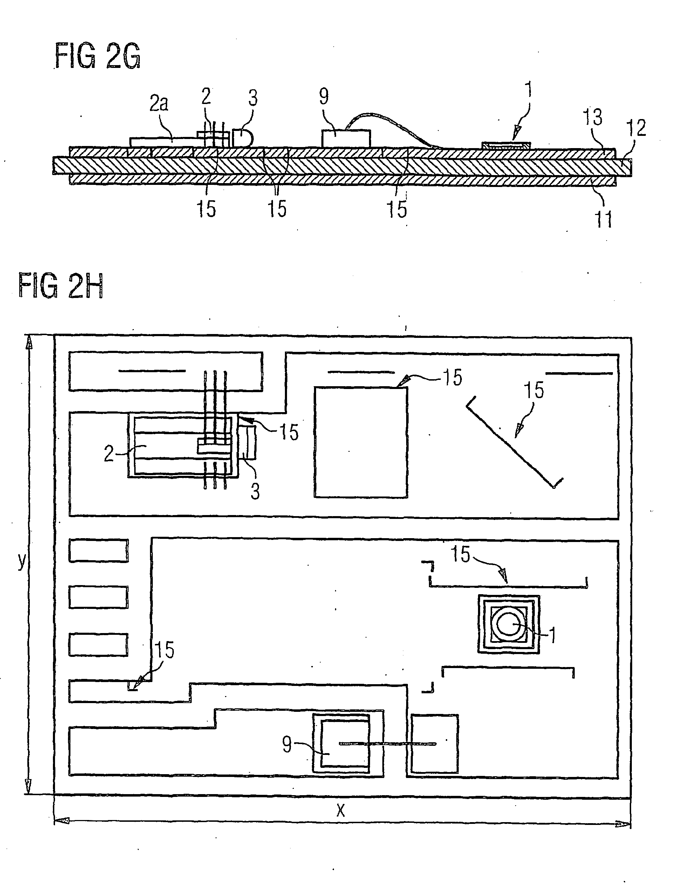

Die Figur 2G zeigt die Pumpeinheit der gemäß dem hier beschriebenen Verfahren hergestellten Halbleitervorrichtung gemäß dem dritten Ausführungsbeispiel vor Bestückung mit passiven optischen Elementen in einer schematischen Seitenansicht, Figur 2H zeigt die zugehörige schematische Draufsicht.

Wie den Figuren 2G und 2H zu entnehmen ist, weist der Anschlussträger 14 Nebenjustagemarken 15 auf. Das heißt es sind in den Anschlussträger 14 Ablagestrukturen 15 strukturiert, die als Orientierungshilfen für ein Bildverarbeitungssystem dienen. Bei den Nebenjustagemarken 15 handelt es sich beispielsweise um Ablagestrukturen, die als fototechnisch strukturierte Dünnschichten ausgeführt sind.

Die Nebenjustagemarken dienen als Orientierungshilfen für ein Bildverarbeitungssystem, mittels dem die Ablagepositionen für die einzelnen Elemente der Halbleitervorrichtung auf dem Anschlussträger 14 ermittelt werden. Die Ablagegenauigkeit für die einzelnen Elemente beträgt dabei vorzugsweise zwischen +/- 5 µm bis +/- 50 µm. Besonders bevorzugt beträgt die Ablagegenauigkeit wenigstens +/- 10 µm.

Beispielsweise beträgt die Breite y des Anschlussträgers 14 zwischen 9 und 13 mm, vorzugsweise zirka 10 mm. Die Länge x des Anschlussträgers 4 beträgt vorzugsweise zwischen 9 und 14 mm, beispielsweise 12 mm.

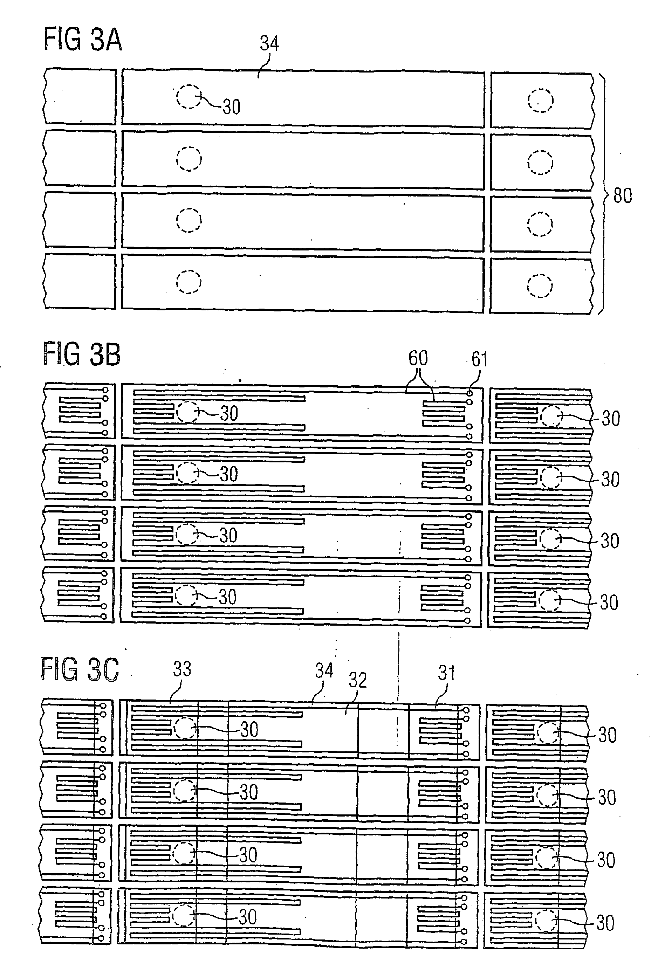

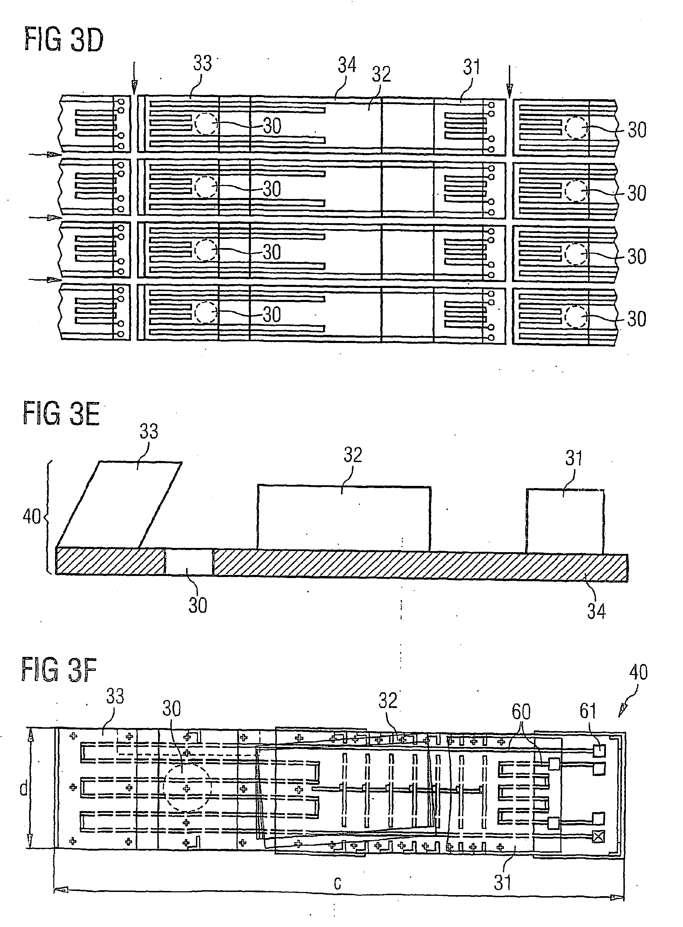

Die Figuren 3A, 3B, 3C und 3D zeigen in einer schematischen Draufsicht die Herstellung von Resonatoraufsätzen 40 gemäß einem Ausführungsbeispiel des hier beschriebenen Verfahrens. Die Figur 3E zeigt in einer schematischen Seitenansicht einen derart hergestellten Resonatoraufsatz 40.

In der Figur 3A ist ein Trägerverbund 80 dargestellt, der eine matrixartige Anordnung einer Vielzahl von Einzelträgerbereichen 34 umfasst. Der Trägerverbund 80 ist zum Beispiel durch einen Siliziumwafer gebildet. Beispielsweise handelt es sich dabei um einen sechs Zoll oder acht Zoll Siliziumwafer. Jeder Einzelträgerbereich 34 weist eine Ausnehmung 30 - beispielsweise eine Bohrung - auf. Die Ausnehmung 30 erlaubt den Durchtritt von Laserstrahlung in und aus dem Resonatoraufsatz 40.

In einem folgenden Verfahrensschritt (siehe Figur 3B) wird eine strukturierte Metallbeschichtung 60 auf die Einzelträgerbereiche 34 strukturiert. Die Metallbeschichtung 60 ist beispielsweise durch eine mäanderartige Platinbeschichtung gebildet, die mittels Kontaktstellen 61 elektrisch kontaktierbar ist.

Im in Verbindung mit Figur 3C beschriebenen Verfahrensschritt werden optische Elemente wie ein Umlenkspiegel 33, ein optisch nicht-linearer Kristall 32 sowie ein Resonatorspiegel 31 auf den Einzelträgerbereichen 34 angeordnet. Vorzugsweise werden die optischen Elemente im Verbund - beispielsweise als Streifen, die eine Vielzahl von Resonatorspiegeln 31 umfassen - auf dem Trägerverbund 80 angeordnet. Auf diese Weise kann gleichzeitig auf einer Vielzahl von Einzelträgerbereichen 34 jeweils eines der optischen Elemente angeordnet werden. Die optischen Elemente können beispielsweise aufgeklebt werden. Vorzugsweise werden die optischen Elemente mittels Bonden, beispielsweise anodischem Bonden, auf den Einzelträgerbereichen 34 befestigt.

In einem abschließenden Verfahrensschritt kann der Trägerverbund 80 wie in Figur 3D dargestellt entlang der dort eingezeichneten Pfeile vereinzelt werden. Dabei können auch die im Verbund angeordneten optischen Elemente vereinzelt werden. Es resultiert eine Vielzahl von Resonatoraufsätzen 40. Ein derartiger Resonatoraufsatz ist beispielsweise in Figur 3E schematisch dargestellt.

Figur 3F zeigt eine schematische Draufsicht auf den Resonatoraufsatz 40. Vorzugsweise beträgt die Länge des Resonatoraufsatzes 40 zwischen c = 8 und c = 12 mm, beispielsweise c = 10 mm. Die Breite des Resonatoraufsatzes 40 beträgt vorzugsweise zwischen d = 1, 75 mm und d = 3 mm, beispielsweise d = 2,15 mm.

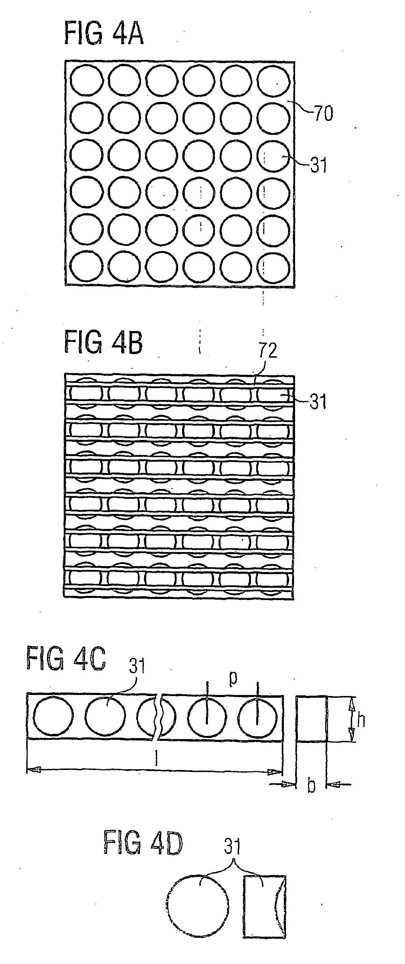

In Verbindung mit den Figuren 4A bis 4D ist ein Herstellungsverfahren zur Herstellung der Resonatorspiegel 31 beschrieben, wie es gemäß eines Ausführungsbeispiels des hier beschrieben Verfahrens zum Einsatz kommt.

Bei diesem Herstellungsverfahren werden beispielsweise Siliziumkugeln in einen Glaswafer 70 geprägt, sodass eine Vielzahl von Resonatorspiegeln 31 in einem Array erzeugt werden können. Figur 4A zeigt die zugehörige schematische Draufsicht auf ein derart erzeugtes Array.

Figur 4B zeigt die Vereinzelung des Arrays 70 entlang von Linien 72. Dadurch werden die in Figur 4C dargestellten Streifen von Mikrospiegeln 31 erzeugt. Eine solche Stange von Mikrospiegeln weist beispielsweise eine Länge 1 von zirka 100 mm auf. Der Abstand p der einzelnen Mikrospiegel 31 von einander beträgt zirka 2 mm. Die Höhe h der Stange beträgt vorzugsweise zirka 2 mm, die Breite b beträgt vorzugsweise zwischen 0,7 und 2,5 mm.

Eine solche Stange von Mikrospiegeln kann zum Beispiel auf einen Trägerverbund 80 wie er in den Figuren 3A bis 3D gezeigt ist, aufgebracht werden und gemeinsam mit dem Trägerverbund 80 vereinzelt werden. Es ist jedoch auch möglich, dass die Streifen vor Aufbringen auf Einzelträgerbereiche 34 zu einzelnen Resonatorspiegeln 31 vereinzelt werden. Solche Resonatorspiegel 31 sind in der

Figur 4D in Draufsicht und Schnittansicht schematisch dargestellt.

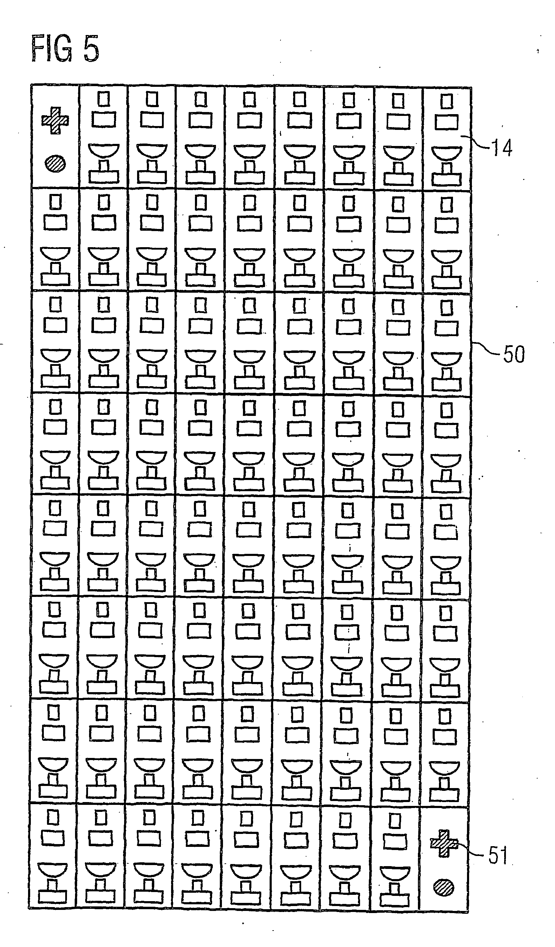

Figur 5 zeigt einen Anschlussträgerverbund 50 mit einer Vielzahl von matrixartig angeordneten Anschlussträgern 14 wie er in einem Ausführungsbeispiel des hier beschriebenen Verfahrens Verwendung findet.

Der Anschlussträgerverbund 50 weist Hauptjustagemarken 51 auf, die diagonal an zwei Ecken des Anschlussträgerverbunds 50 angeordnet sind. Bei den Hauptjustagemarken 51 kann es sich beispielsweise um Dünnschichtstrukturierungen im Material des Anschlussträgerverbunds 50 handeln. Weiter ist es möglich, dass es sich bei den Hauptjustagemarken 51 um Justagechips handelt, die beispielsweise aus Silizium, Glas oder einer Keramik bestehen können. Diese Justagechips können Dünnschichtstrukturierungen aufweisen. Die Hauptjustagemarken dienen zur Justage aller Elemente auf dem Anschlussträgerverbund 50. Der Anschlussträgerverbund 50 bildet dabei einen Nutzen. Da die Einzelelemente im Nutzen eine Einheit darstellen, sind folgende Montageprozesse möglich:
- Montage von Elementen als Streifen in einem Schritt und späteres Vereinzeln zusammen mit dem Nutzen,
- Aufbringen von Prismenstreifen oder Linsenstreifen,
- Montage von Einzelteilen, die in einem Saugwerkzeug matrixförmig und selbstjustierend eingelegt sind.

Aufgrund der regelmäßigen matrixartigen Anordnung der Anschlussträger 14 im Anschlussträgerverbund 50 ist eine sequenzielle oder eine gleichzeitige Anordnung einer Vielzahl von Elementen in einem Schritt möglich.

Die Vereinzelung des Anschlussträgerverbunds kann beispielsweise durch Sägen oder Ritzen und Brechen erfolgen. Dabei wird der Anschlussträgerverbund 50 vorzugsweise auf einer Klebefolie in einen Rahmen gespannt.

Der Anschlussträgerverbund 50.hat vorzugsweise eine Größe von 50 mm x 50 mm bis 200 mm x 200 mm. Er kann rund oder rechteckig sein. Vorzugsweise beträgt die Oberflächenrauhigkeit der Anschlussträgeroberseite weniger als 1 µm. Dies ermöglicht eine besonders genaue Justage der einzelnen Elemente auf dem Anschlussträger.

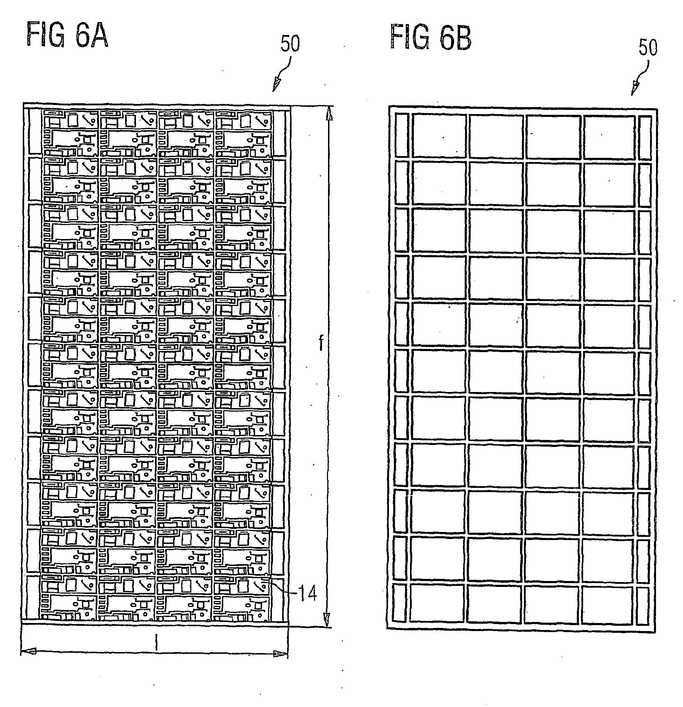

Figur 6A zeigt eine schematische Draufsicht auf einen Anschlussträgerverbund 50 mit einer Vielzahl von matrixartig angeordneten Anschlussträgern 14, wie er in einem weiteren Ausführungsbeispiel des hier beschriebenen Verfahrens Verwendung findet.

Die Länge f des Anschlussträgerverbundes 50 beträgt beispielsweise zwischen 100 und 120 mm, vorzugsweise 110 mm. Die Breite e des Anschlussträgerverbundes 50 beträgt vorzugsweise zwischen 45 und 65 mm, beispielsweise 55 mm. Der Anschlussträgerverbund 50 umfasst in diesem Ausführungsbeispiel 11 mal 4 Anschlussträger 14.

Figur 6B zeigt eine schematische Draufsicht auf die Rückseite des Anschlussträgerverbunds 50.

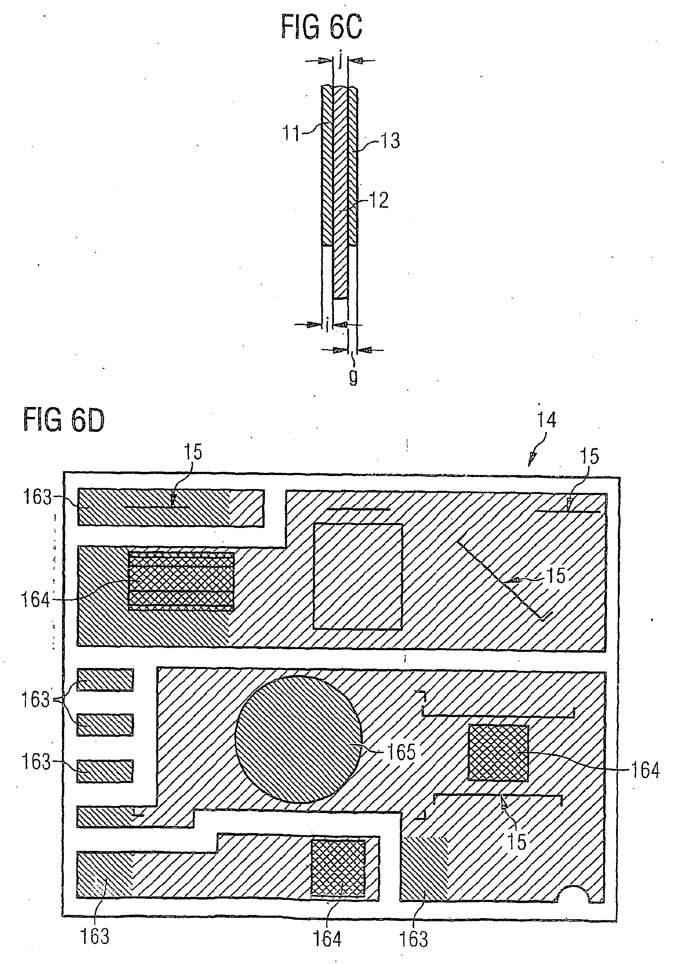

Figur 6C zeigt eine schematische Seitenansicht des Anschlussträgerverbunds 50. Die Breite j des Grundkörpers 12, der beispielsweise ein Aluminiumnitrid enthält oder der aus einem Aluminiumnitrid besteht, beträgt vorzugsweise zwischen 0,25 und 0,45 mm, beispielsweise 0,38 mm. Die Dicke i der Unterseitenmetallisierung 11, die beispielsweise aus Kupfer besteht, beträgt vorzugsweise zwischen 0,2 und 0,4 mm, beispielsweise 0,3 mm. Die Dicke g der strukturierten Oberseitenmetallisierung 13, die beispielsweise aus Kupfer besteht beträgt vorzugsweise zwischen 0,2 und 0,3 mm, beispielsweise 0,25 mm.

Figur 6D zeigt eine schematische Draufsicht auf einen Anschlussträger 14 des Anschlussträgerverbundes 50. Der Anschlussträger 14 weist Drahtbondflächen 163 auf, die zum elektrischen Kontaktieren von Komponenten auf dem Anschlussträger 14 mittels eines Bonddrahts vorgesehen sind. Weiter weist der Anschlussträger 14 Lötflächen 164 auf, auf die aktive Komponenten aufgebracht werden können. Ferner weist der Anschlussträger 14 eine Lötstoppschicht 165 auf.

Die mit einem der hier beschriebene Verfahren hergestellte Halbleitervorrichtung zeichnet sich unter anderem durch ihre besonders kompakte Bauform aus. Dies ermöglicht beispielsweise eine Resonatorlänge von wenigen Millimeter, bevorzugt höchstens 15 mm, besonders bevorzugt höchstens 10 mm. Eine solch kurze Resonatorlänge ermöglicht besonders schnelle Ansprechzeiten bei der Lasererzeugung, wie sie beispielsweise für optische Projektionsanwendungen vorteilhaft sind. Die mit einem der hier beschriebene Verfahren hergestellte Halbleitervorrichtung zeichnet sich fernen unter anderem dadurch aus, dass insbesondere die im Betrieb Wärme erzeugenden Komponenten wie die Pumpstrahlungsquelle und der oberflächenemittierende Halbleiterkörper in Planarmontage auf einem Träger mit hoher thermischer Leitfähigkeit aufgebracht sind. Dadurch kann die im Betrieb erzeugte Wärme direkt an den Träger abgegeben werden und muss nicht beispielsweise um einen bestimmten Winkel umgelenkt werden. Weiter ermöglicht die thermische Entkopplung von Pumpeinheit und Resonatoraufsatz eine besonders stabile Temperatur des optisch nicht-linearen Kristalls. Auf diese Weise kann beispielsweise besonders gleichmäßige Laserstrahlung im sichtbaren Bereich erzeugt werden.

Diese Patentanmeldung beansprucht die Prioritäten der deutschen Patentanmeldungen 102005063103.7 und 102006017293.0.

## Patentansprüche

1. Verfahren zur Herstellung einer optisch pumpbaren Halbleitervorrichtung, mit den folgenden Schritten:
- Bereitstellen eines Anschlussträgerverbunds (50) umfassend eine Mehrzahl von Anschlussträger (14), die mechanisch fest miteinander verbunden sind, wobei die Anschlussträger (14) im Anschlussträgerverbund (50) matrixartig angeordnet sind,
- Anordnen genau eines oberflächenemittierenden Halbleiterkörpers (1) auf jedem Anschlussträger (14) des Anschlussträgerverbunds (50),
- Anordnen genau einer Pumpstrahlungsquelle (2) auf jedem Anschlussträger (14) des Anschlussträgerverbunds (50), die geeignet ist, den auf denselben Anschlussträger angeordneten oberflächenemittierenden Halbleiterkörper optisch zu pumpen, wobei der Halbleiterkörper jeweils in einer Montageebene des Halbleiterkörpers zwischen Pumpstrahlungsquelle und einem optischen Element (7), welches sich auf jedem Anschlussträger befindet, entlang einer geraden Linie angeordnet wird, sodass im Betrieb erzeugte Pumpstrahlung über den Halbleiterkörper hinweg läuft, bevor sie mittels des optischen Elements (7) auf eine Strahlungsdurchtrittsfläche des Halbleiterkörpers gelenkt wird, und
- Vereinzeln des Anschlussträgerverbunds in einzelne Anschlussträger.

2. Verfahren gemäß dem vorherigen Anspruch, wobei ein Verbund gleichartiger Elemente auf den Anschlussträgerverbund (50) aufgesetzt wird.

3. Verfahren gemäß zumindest einem der vorherigen Ansprüche, wobei der Anschlussträgerverbund (50) zwei Hauptjustagemarken (51) aufweist, die als Strukturierungen des Anschlussträgerverbundes oder als Justagechips ausgebildet sind.

4. Verfahren gemäß zumindest einem der vorherigen Ansprüche, wobei ein Anschlussträger (14) des Anschlussträgerverbunds (50) zumindest eine Nebenjustagemarke (15) aufweist, die durch eine Ablagestruktur gebildet ist.

5. Verfahren gemäß zumindest einem der vorherigen Ansprüche, mit dem folgenden Schritt:
- Anordnen eines Resonatoraufsatzes (40) zur Bildung eines Resonators beinhaltend den oberflächenemittierenden Halbleiterkörper (1) auf einem Anschlussträger (14).

6. Verfahren zur Herstellung eines Resonatoraufsatzes für eine gemäß dem vorherigen Anspruch hergestellte optisch pumpbare Halbleitervorrichtung, mit den folgenden Schritten:
- Bereitstellen eines Trägerverbunds (80), umfassend eine Mehrzahl von Einzelträgerbereichen (34), die mechanisch fest miteinander verbunden sind,
- Anordnen eines Resonatorspiegels (31) auf einen Einzelträgerbereich,
- Fertigstellen einzelner Resonatoraufsätze (40).

7. Verfahren gemäß dem vorherigen Anspruch, mit dem folgenden Schritt:
- Anordnen eines Strahlungsumlenkelements (33) auf einen Einzelträgerbereich (34) des Trägerverbunds (80).

8. Verfahren gemäß zumindest einem der Ansprüche 6 oder 7, wobei die Einzelträgerbereiche (34) im Trägerverbund (80) matrixartig angeordnet sind.

9. Verfahren gemäß dem vorherigen Anspruch, wobei ein Verbund gleichartiger Elemente auf den Trägerverbund (80) aufgesetzt wird.

10. Verfahren gemäß zumindest einem der Ansprüche 6 bis 9, wobei auf einem Einzelträgerbereich (34) des Trägerverbunds (80) zumindest ein Element mittels Bonden befestigt wird.

11. Verfahren gemäß zumindest einem der Ansprüche 6 bis 10, wobei eine strukturierte Metallschicht (60) auf einem Einzelträgerbereich des Trägerverbunds (80) aufgebracht wird, die elektrisch kontaktierbar ist.

12. Verfahren gemäß zumindest einem der Ansprüche 5 bis 11, wobei jeder Resonatoraufsatz (40) elektrisch leitend mit dem zugehörigen Anschlussträger (14) verbunden wird.

## Claims

1. Method for producing an optically pumpable semiconductor device, comprising the following steps:
- providing a connection carrier assemblage (50) comprising a plurality of connection carriers (14) which are mechanically fixedly connected to one another, wherein the connection carriers (14) in the connection carrier assemblage (50) are arranged in a matrix-like manner,
- arranging exactly one surface emitting semiconductor body (1) on each connection carrier (14) of the connection carrier assemblage (50),
- arranging exactly one pump radiation source (2) on each connection carrier (14) of the connection carrier assemblage (50), said source being suitable for optically pumping the surface emitting semiconductor body arranged on the same connection carrier, wherein the semiconductor body is in each case arranged along a straight line in a mounting plane of the semiconductor body between pump radiation source and an optical element (7) situated on each connection carrier, such that pump radiation generated during operation passes across the semiconductor body before it is directed onto a radiation passage area of the semiconductor body by means of the optical element (7),
- singulating the connection carrier assemblage into individual connection carriers.

2. Method according to the preceding claim,
wherein an assemblage of elements of identical type is placed onto the connection carrier assemblage (50).

3. Method according to at least one of the preceding claims,
wherein the connection carrier assemblage (50) has two main alignment marks (51) embodied as structuring of the connection carrier assemblage or as alignment chips.

4. Method according to at least one of the preceding claims,
wherein a connection carrier (14) of the connection carrier assemblage (50) has at least one secondary alignment mark (15) formed by a placement structure.

5. Method according to at least one of the preceding claims, comprising the following step:
- arranging a resonator attachment (40) for forming a resonator comprising the surface emitting semiconductor body (1) on a connection carrier (14).

6. Method for producing a resonator attachment for an optically pumpable semiconductor device produced according to the preceding claim, comprising the following steps:
- providing a carrier assemblage (80), comprising a plurality of individual carrier regions (34) which are mechanically fixedly connected to one another,
- arranging a resonator mirror (31) on an individual carrier region,
- completing individual resonator attachments (40).

7. Method according to the preceding claim, comprising the following step:
- arranging a radiation deflecting element (33) on an individual carrier region (34) of the carrier assemblage (80).

8. Method according to at least one of Claims 6 and 7,
wherein the individual carrier regions (34) in the carrier assemblage (80) are arranged in a matrix-like manner.

9. Method according to the preceding claim,
wherein an assemblage of elements of identical type is placed onto the carrier assemblage (80).

10. Method according to at least one of Claims 6 to 9,
wherein at least one element is fixed on an individual carrier region (34) of the carrier assemblage (80) by means of bonding.

11. Method according to at least one of Claims 6 to 10,
wherein a structured metal layer (60) is applied on an individual carrier region of the carrier assemblage (80), and electrical contact can be made with said metal layer.

12. Method according to at least one of Claims 5 to 11,
wherein each resonator attachment (40) is electrically conductively connected to the associated connection carrier (14).

## Revendications

1. Procédé de fabrication d'un ensemble semi-conducteur optiquement pompable, le procédé présentant les étapes suivantes :
préparer un ensemble (50) de porte-bornes comprenant plusieurs porte-bornes (14) reliés les uns aux autres de manière mécaniquement solidaire, les porte-bornes (14) étant disposés en matrice dans le composite (50) de porte-bornes,
agencer exactement un corps semi-conducteur (1) à émission de surface sur chacun des porte-bornes (14) du composite (50) de porte-bornes,
agencer exactement une source (2) de rayonnement de pompage sur chaque porte-borne (14) de l'ensemble (50) de porte-bornes, la source convenant pour pomper optiquement le corps semi-conducteur à émission de surface disposé sur le même porte-borne, chaque corps semi-conducteur s'étendant en ligne droite dans un plan de montage du corps semi-conducteur entre la source de rayonnement de pompage et un élément optique (7) situé sur chaque porte-borne de telle sorte que le rayonnement de pompage formé en fonctionnement s'éloigne par l'intermédiaire du corps semi-conducteur avant d'être dévié au moyen de l'élément optique (7) sur une surface de sortie de rayonnement du corps semi-conducteur et
découper l'ensemble de porte-bornes en porte-bornes séparés.

2. Procédé selon la revendication précédente, qui utilise un ensemble d'éléments identiques dans l'ensemble (50) de porte-bornes.

3. Procédé selon au moins l'une des revendications précédentes, dans lequel l'ensemble (50) de porte-bornes présente des repères principaux d'ajustement (51) configurés comme structurations de l'ensemble de porte-bornes ou comme puces d'ajustement.

4. Procédé selon au moins l'une des revendications précédentes, dans lequel un porte-bornes (14) de l'ensemble (50) de porte-bornes présente au moins un repère secondaire d'ajustement (15) formé par une structure déposée.

5. Procédé selon au moins l'une des revendications précédentes, présentant l'étape suivante :
agencer sur un porte-bornes (14) une garniture de résonateur (40) en vue de former un résonateur contenant le corps semi-conducteur (1) à émission de surface.

6. Procédé de fabrication d'une garniture de résonateur pour un dispositif semi-conducteur pompable optiquement fabriqué selon la revendication précédente, le procédé comportant les étapes suivantes :
préparer un ensemble (80) de supports qui comporte plusieurs zones (34) de supports individuels reliés les uns aux autres de manière mécaniquement solidaire,
agencer un miroir de résonateur (31) sur une zone de support individuelle et
former les garnitures de résonateur (40) séparées.

7. Procédé selon la revendication précédente, comportant l'étape suivante :
agencer un élément (33) de déviation de rayonnement sur une zone (34) de support individuel de l'ensemble (80) de supports.

8. Procédé selon au moins l'une des revendications 6 ou 7, dans lequel les différentes zones de support (34) sont disposées en matrice dans l'ensemble (80) de supports.

9. Procédé selon la revendication précédente, dans lequel un ensemble d'éléments identiques est placé sur l'ensemble (80) de supports.

10. Procédé selon au moins l'une des revendications 6 à 9, dans lequel au moins un élément est fixé par collage sur une zone (34) de supports individuels de l'ensemble (80) de supports.

11. Procédé selon au moins l'une des revendications 6 à 10, dans lequel une couche métallique structurée (60) est appliquée sur une zone de supports individuels de l'ensemble (80) de supports et peut être mise en contact électrique.

12. Procédé selon au moins l'une des revendications 5 à 11, dans lequel chaque garniture de résonateur (40) est reliée de manière électriquement conductrice au porte-bornes (14) associé.
